Europäisches Patentamt

European Patent Office

Office européen des brevets

(19)

(11) EP 1 086 532 B1

(12) **EUROPEAN PATENT SPECIFICATION**

(45) Date of publication and mention
of the grant of the patent:
**22.09.2004 Bulletin 2004/39**

(21) Application number: **99924471.8**

(22) Date of filing: **21.05.1999**

(51) Int Cl.⁷: **H03M 11/24**, H03M 1/00,
H03M 1/18
// H03M1:36

(86) International application number:
**PCT/US1999/011412**

(87) International publication number:
**WO 1999/062180 (02.12.1999 Gazette 1999/48)**

(54) **DIFFERENTIATING BETWEEN INPUT RANGES IN A PASSIVE KEYPAD**

UNTERSCHEIDUNG ZWISCHEN EINGANGSBEREICHEN IN EINER PASSIVEN TASTATUR

DIFFERENCIATION DE GAMMES D'ENTREE DANS UN CLAVIER PASSIF

(84) Designated Contracting States:
**CH DE ES FI FR GB IT LI NL SE**

(30) Priority: **22.05.1998 US 83637**

(43) Date of publication of application:
**28.03.2001 Bulletin 2001/13**

(73) Proprietor: **QUALCOMM INCORPORATED**
**San Diego, CA 92121-1714 (US)**

(72) Inventors:
• **KERR, Richard, J.**
**San Diego, CA 92130 (US)**

• **CLAXTON, Daniel, D.**
**Rancho Santa Fe, CA 92067 (US)**

(74) Representative: **Walsh, Michael Joseph et al**
**TOMKINS & CO.**
**5, Dartmouth Road**
**Dublin 6 (IE)**

(56) References cited:
**DE-C- 4 328 663          US-A- 5 343 200**

**Description**

**BACKGROUND OF THE INVENTION**

**I. Field of the Invention**

The present invention relates to passive keypads. More particularly, the present invention relates to a novel and improved method and circuit for differentiating between various input ranges in a passive keypad.

II. **Description of the Related Art**

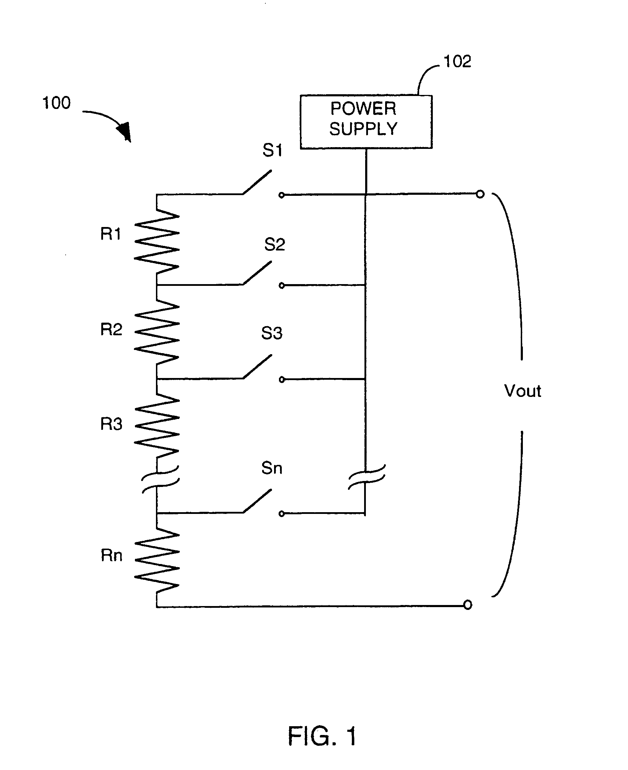

Passive network keypads are well known in the art for use as user input devices. One example of such a passive network keypad is a resistive ladder network. As is known in the art, a resistive ladder network comprises a plurality of resistors connected in series, with each resistor being selectively coupled to a power supply through a respective switch. An exemplary configuration of a resistive ladder network **100** is shown in FIG. 1. Power supply **102** typically includes a voltage or current source, and a pull-up resistor. Resistors R1-Rn are coupled in series. Switches S1-Sn are coupled to bypass or shunt all resistors which are "higher" in the ladder (i.e., closer to the power supply **102** in the series configuration) while coupling the power supply **102** through all remaining resistors which are "lower" in the ladder (i.e., farther away from the power supply **102** in the series configuration). When one of the switches S1-Sn is closed, a corresponding voltage, Vout, appears across the output terminals of the resistive ladder 100. The magnitude of the output voltage Vout depends on which switch S1-Sn was closed.
For example, if switch S3 is closed, current from power supply 102 flows through S3, bypassing resistors R1 and R2. The current flows through resistors R3 through Rn. Thus, by Ohm's law, the output voltage Vout for the closure of any switch, Sx, will equal:

$$\text{Vout} = i * \sum_{j=x}^{n} Rj \qquad (1)$$

where i is equal to the current generated by power supply **102**, n is the total number of switches in the resistive ladder, and Rj is the jth resistor in the resistive ladder.
Since it is easy to calculate the expected output voltage for each switch closure, and thereby determine which switch was pressed, resistive ladder networks are convenient ways to encode a passive network keypad. And since passive network keypads require no active components to function, they are desirable for use in portable electronic equipment because they consume no power when in their static state. Thus, passive network keypads are particularly suitable for use as input devices in wireless communication devices such as cellular or PCS-band wireless telephones.
However, one drawback to using a passive network keypad in a wireless communication device is that it generates only an analog voltage level as an output. As such, the analog voltage level must be decoded in order to determine which key was pressed. Decoding which key was pressed requires the operation of a processor which consumes current, which thereby drains the battery in the wireless communication device. Furthermore, decoding which key was pressed also requires processor time, which takes time away from other functions that the processor may be performing at the time the key was pressed. If the keypress was inadvertent or superfluous, then the current and time spent by the processor to decode which key was pressed is wasted.
An additional drawback of a typical passive network keypad in a wireless communication device is that the processor typically must poll an analog-to-digital converter (ADC) at the output of the keypad at some predefined interval to detect key presses. To the extent that the processor is polling the keypad ADC when no keys have been pressed, this also uses processor time and current unnecessarily.
What is needed is a method and circuit for differentiating between input ranges in a passive network keypad which allows the proper processing of meaningful keypresses, while ignoring inadvertent or superfluous keypresses, and while avoiding excessive polling of the keypad, thereby conserving power and processor time.
German Patent No. DE 43 28 663 "Grundig EMV" discloses an interrogation device used for operating control switches arranged in groups, with a resistance network providing a characteristic voltage drop signal upon operation of one of the operating controls, which is supplied via a converter to an evaluation control device.
US Patent No. US 5, 343, 200 "Canon Kabushiki Kaisha" discloses an analog or a digital converter in which an automatic gain control circuit is based upon simple processing capable of being performed without using an amplifier composed of complicated analog circuitry, in which signal processing is carried out using an inexpensive processor.

## SUMMARY OF THE INVENTION

The present invention, as set out in the appended claims, is a novel and improved method and circuit for processing switch closures in a passive network having switches. The passive network generates an output voltage in response to a switch closure. The circuit comprises a comparison circuit, coupled to the passive network, for comparing the output voltage to a reference voltage. A decoder, coupled to the comparison circuit, decodes the switch closure if the output voltage is within a predetermined range, and does not decode said switch closure if the output voltage is not within the predetermined range.

In the preferred embodiment, the comparison circuit comprises at least one comparator, each comparator having a first input coupled to the passive network. A respective reference voltage generator is coupled to a second input of each one of the comparators. Each of the reference voltage generators generates a respective reference voltage which define the predetermined range.

In one embodiment, the comparison circuit further comprises a range determination logic circuit coupled to each of the comparator outputs. The range determination logic distinguishes between different ranges of the output voltages generated by the passive network.

Also in the preferred embodiment, the comparison circuit comprises a first comparator for generating a comparison signal only if a first predetermined subset of the switches is closed; and a second comparator for generating a comparison signal only if a second predetermined subset of switches is closed. In this embodiment, the comparison circuit generates an interrupt signal to the decoder only if the output voltage is within the predetermined range, which corresponds to a predetermined subset of switches. According to the invention there is provided a switch corresponding to a power-on key. The comparison circuit generates an interrupt signal to the decoder only if the said switch is closed.

In another embodiment, the circuit further comprises a controller, coupled to the decoder, for altering an input voltage of the passive network in response to the decoder decoding said switch closure. By altering the input voltage of the passive network, the output voltage range is likewise altered. As a result the subset of switches which generate an interrupt is altered for a given comparison reference voltage.

## BRIEF DESCRIPTION OF THE DRAWINGS

The features, objects, and advantages of the present invention will become more apparent from the detailed description set forth below when taken in conjunction with the drawings in which like reference characters identify correspondingly throughout and wherein:

FIG. 1 is a circuit-level diagram of a resistive ladder network;

FIG. 2 is a functional block diagram of the circuit of the present invention;

FIG. 3 is a circuit-level diagram of a preferred embodiment of the reference voltage generators and comparators of FIG. 2; and

FIG. 4 is a flow diagram of the method of the present invention.

## DETAILED DESCRIPTION OF THE PREFERRED EMBODIMENTS

The present invention is applicable to any portable or fixed electronic equipment which uses a passive network to encode a user input, such as a keypad. Thus, the present invention is particularly applicable to portable electronic devices such as wireless communication devices in which it is desirable to conserve battery power and processor compute time. As defined herein, "key press" means any activation of the user input, for example the pressing of a mechanical keyswitch on a standard telephone keypad.

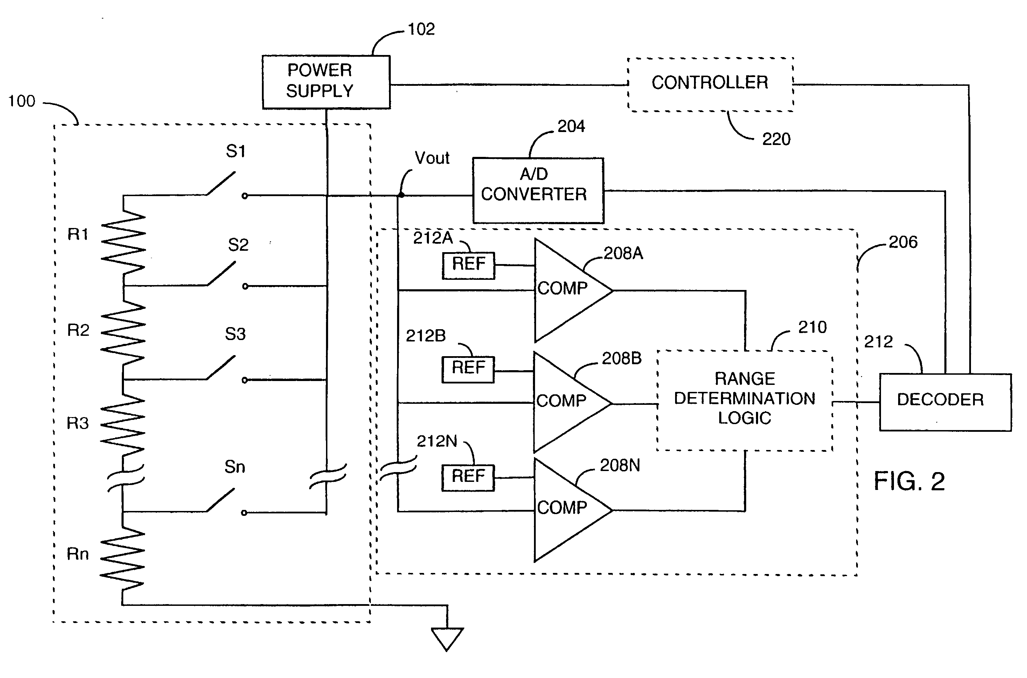

Turning now to FIG. 2, a functional block diagram of the circuit of the present invention is illustrated. Resistive ladder network **100** and power supply **102** are identical to those described with reference to FIG. 1. Thus, the magnitude of the voltage Vout is dependent upon which switch S1-Sn was closed.

An analog to digital converter (A/D) **204** converts the analog voltage Vout to a digital key press signal representative of which switch S1-Sn was closed, for example by the user pressing an associated keyswitch on a keypad (not shown). As is known in the art, A/D converter **204** samples Vout at a predetermined rate to generate the digital keypress signal. A/D converter **204** may be any off-the-shelf A/D converter of any suitable bit width as is known in the art. For example, A/D converter may generate a 5-bit wide digital keypress signal, thereby being able to distinguish among $2^5$ different levels of Vout. Such a configuration would be able to support 32 different switches S1-S32.

A/D converter **204** passes the digital keypress signal to decoder **212** for determination of which switch was closed. Decoder **212** determines, from the digital keypress signal generated by A/D converter **204**, which switch S1-Sn was closed. For example, decoder **212** may compare the digital keypress signal to a correspondence table of stored values. Each value in the correspondence table may correspond to a particular keypress. Alternately, decoder **212** may perform a mathematical operation on the digital keypress signal to determine which switch S1-Sn was closed. Decoder **212** may comprise any general purpose microprocessor and associated memory programmed to perform the decoding operation described herein.

As discussed above in the Background of the Invention, decoding which key was pressed requires the operation of a decoder **212** which consumes current, which thereby drains the battery in the wireless communication device. Furthermore, decoding which key was pressed also requires processor time, which takes time away from other functions that the processor to which decoder **212** may belong may be performing at the time the key was pressed. If the key press was inadvertent or superfluous, then the current and time spent by the processor to decode which key was pressed is wasted.

This is particularly true if the wireless communication device using the resistive ladder network **100** operates in a "sleep" mode, whereby it powers down the majority of its hardware components, including decoder **212** and A/D converter **204** when they are not required. Using this sleep mode conserves battery power, leading to longer operating and standby times.

In order to avoid consuming decoder **212** processing cycles, or waking up decoder **212** when it is powered down, the present invention utilizes a comparison circuit **206** to gate or screen interrupts to decoder **212**.

An exemplary first embodiment of comparison circuit **206** is illustrated in FIG. 2. In this embodiment, comparison circuit **206** preferably comprises at least one comparator **208A-208N**, and a corresponding at least one reference voltage generator **212A-212N**. One input of the at least one comparator **208A-208N** is coupled to the Vout terminal of resistive ladder network **100**. A second input of the at least one comparator **208A-208N** is coupled to the output of the corresponding at least one reference voltage generator **212A-212N**. In the preferred embodiment, each reference voltage generator **212A-212N** generates a different reference voltage level for its corresponding comparator **208A-208N**.

In operation, each comparator **208A-208N** senses the voltage level Vout and compares it with the reference voltage generated by its corresponding reference voltage generator **212A-212N**. Each comparator **208A-208N** then outputs a comparison signal indicative of the result of the comparison. For example, in the preferred embodiment if the voltage Vout is less than the threshold reference voltage, then the comparator 208A-208N outputs a logic level "high". If, on the other hand, the voltage Vout is greater than the threshold reference voltage, then the comparator **208A-208N** outputs a logic level "low". In other words, in the preferred embodiment, the comparators **208A-208N** are configured as "less than" type comparators. In alternate embodiments, comparators **208A-208N** may be configured as "greater than" type comparators.

Comparators **208A-208N** is preferably any suitable off-the-shelf opamp comparator as is known in the art. However, there are many other means for comparing two signals that are known in the art. For example, a transistor gate, a zener diode, or other device as is known in the art may be used in place of comparators **208A-208N**, and indeed the whole of comparison circuit **206**.

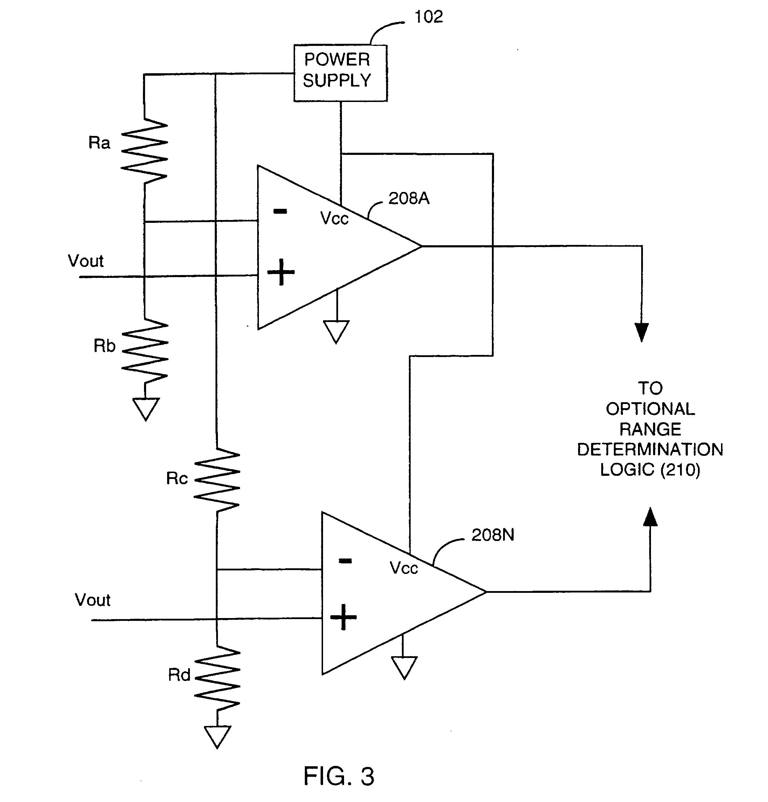

Reference voltage generators **212A-212N** are preferably resistive voltage divider circuits and an associated power supply. For example, power supply **102** may be divided down by resistive voltage dividers internal to reference voltage generators **212A-212N** to generate the respective threshold reference voltages. An exemplary implementation of comparators **208A-208B** and reference voltage generators **212A-212B** is illustrated in FIG. 3.

In FIG. 3, power supply **102** is divided down by resistors Ra and Rb to provide the threshold reference voltage for comparator **208A**. Likewise, resistors Rc and Rd generate the threshold reference voltage for comparator **208B**. The choice of the value of resistors Ra-Rd is dependent on the threshold voltage level that is desired for Vout to meet before the comparators **208A** and **208B** are triggered.

In the preferred embodiment, the range for Vout is from about .01 volts to 1.5 volts. In other words, the values of resistors **R1-Rn** (FIG 2) are chosen such that when switch Sn (FIG. 2) is closed, the voltage level of Vout is about .01 volts, and when switch S1 is closed, the voltage level of Vout is about 1.5 volts. Thus, if it is desired that only switch Sn trigger comparator **208N**, then the values of Rc and Rd are chosen such that the threshold reference voltage for comparator **208N** is greater than .01 volts. For the exemplary power supply voltage of 3.3 volts, an exemplary choice for Rc is 1 Megohm, and Rd is 30.9 Kilohms. Furthermore, if it is desired that any switch S1-Sn trigger comparator **208A**, then for the exemplary power supply voltage of 3.3 volts, an exemplary choice for Ra is 511 Kilohms, and Rb is 453 Kilohms.

Referring again to FIG. 2, the outputs of comparators **208A-208N** may be coupled to optional range determination logic **210**. Range determination logic **210** functions to distinguish which range or subset of switches S1-Sn has been closed. For example, if comparator **208A** is configured to trigger as described above for any switch S1-Sn, and comparator **208B** is configured to trigger as described above only for switch Sn, then simple combinatorial logic (i.e., an AND gate with one inverted input) will be able to determine whether one of the switches in the range S1-Sn-1 was closed (i.e., Vout < 1.5 volts, and not Vout < .1 volts). It will be clear to one of ordinary skill in the art that by configuring the threshold voltages, higher-than or lower-than comparisons, and range determination logic **210** to various combinations, it is possible to distinguish among any range of switch closures S1-Sn as desired.

The physical implementation of comparison circuit **206** does not limit the present invention. The number of comparators **208A-208N**, the type of comparison utilized, and the range determination logic 210 may be accomplished in many different ways without departing from the present invention.

In summary, comparison circuit **206** functions to allow only certain predetermined switch closures, or combination of switch closures, to generate an interrupt signal to decoder **212**. For example, if the present invention is implemented in a wireless communication device which utilizes sleep modes to conserve battery power, the comparison circuit **206** may be configured to generate an interrupt to decoder **212** only when switch Sn is closed, where switch Sn corresponds to a "Power On" key. In such a case, decoder **212** would wake up to read A/D converter **204** only when the "Power On" key was pressed. In this way, the wireless communication device utilizing the present invention would be able to power down decoder **212** and A/D converter **204** completely and still be able to wake up and read the keypad input when required. Additionally, the present invention allows a partially or fully interrupt-driven method of operation, whereby the decoder **212** is not required to actively poll A/D converter **204**, but rather may be configured only to poll A/D converter **204** when an interrupt is generated by comparison circuit **206**.

In other words, a specific application of the circuit of FIG. 2 is to prevent all other keys except the "Power On" key from waking up the decoder **212** when it is powered off. This will be useful, for example, if the wireless communication device is carried in a purse or briefcase where it may contact foreign objects which inadvertently activate the keypad. In such a case, it is desirable to ignore all key presses except for the "Power On" key to avoid spending time and power evaluating superfluous key presses.

Another application of the circuit of FIG. 2 is to prevent all but a specific range of keys from interrupting the processor of which decoder **212** may be a part. This will be useful, for example, when the user is scrolling through menus in which only a subset of keys represent valid inputs. In such a case, it would also be desirable to ignore all invalid key presses to avoid spending time and power evaluating superfluous key presses.

In another embodiment, decoder **212** may, upon detecting a predetermined switch closure or combination of switch closures, notify controller **220** that the predetermined switch closure was detected and decoded. In response to this closure, controller **220** directs power supply **102** to alter the input voltage to resistive ladder network **100**, for example, by turning on or off a switchable voltage or current source, or varying a variable voltage or current source. By altering the input voltage to resistive ladder network **100**, the output voltage Vout will be shifted by a corresponding amount for each switch closure. In other words, if the input voltage to resistive ladder network **100** is increased by 1 volt, a corresponding 1 volt shift in Vout for each switch closure will be observed.

If the threshold reference voltages generated by reference voltage generators **212A-212N** remain constant when the input voltage to resistive ladder network **100** is altered, the range of switches S1-Sn which trigger each comparator **208A-208N** will likewise be altered. Thus, continuing the above example where comparator **208N** was only triggered by the closure of switch Sn at, if the input voltage to resistive ladder network **100** is lowered sufficiently, then comparator **208N** may also be triggered by the closure of switch Sn-1. Alternately, it is clear that one can also keep the input voltage to resistive ladder network **100** constant, and instead alter the threshold reference voltages generated by reference voltage generators **212A-212N** in order to "shift" the range of switches S1-Sn which trigger each comparator **208A-208N**.

It can easily be seen that by altering the input voltage to resistive ladder network **100**, the corresponding shift in the range of Vout may be used to allow a different range of key presses to generate interrupts to decoder **212**. A useful application of this facet of the present invention is to assign the "Power On" functionality to switch Sn, and configuring comparison circuit **206** to generate an interrupt for decoder **212** only when a voltage as small as the one generated by the closure of switch Sn is present at Vout. Then, upon detecting and decoding the closure of switch Sn in decoder **212**, controller **220** directs power supply **102** to lower the input voltage to resistive ladder network **100** sufficiently that the closure of any switch S1-Sn generates an interrupt to decoder **212**. In this manner, only pressing the "Power On" key will wake up decoder **212**, but thereafter and key press will trigger an interrupt to cause decoder **212** to read the output of A/D converter **204**.

Controller **220** may be any microprocessor or microcontroller as is known in the art, and furthermore may be advantageously combined with decoder **212** in the same programmable general purpose microprocessor. Various other configurations of the circuit of FIG. 2 will be apparent to one of ordinary skill in the art. For example, any of the elements of FIG. 2 may be configured to operate based on current levels rather than voltage levels.

In still another embodiment, A/D converter **204** may be removed completely, and comparison circuit **206** may be configured to generate an interrupt for each key pressed. For only a few switches, this may be less expensive. Also, even on a complex keypad, the comparison circuit 206 may be read in fewer processing cycles. This alternate embodiment may be used to encode a keyboard over a long wiring distance, and convert it back into a matrix using comparators and logic.

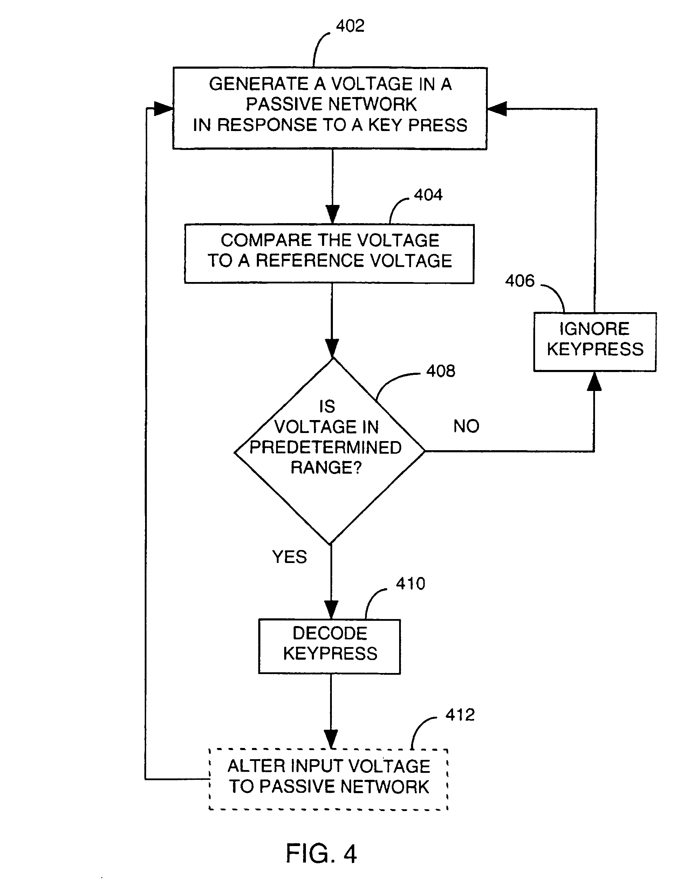

Turning now to FIG. 4, a flowchart of the method of the present invention is shown. The process begins at block **402** where a voltage is generated in a passive network, for example the resistive ladder 100 of FIG. 2, in response to a key press. At block **404**, the voltage is compared to a reference voltage, for example in comparison circuit **206** of FIG. 2. At decision **408**, it is determined whether the generated voltage is within a predetermined range. If it is not, the key press which initiated the voltage is ignored (i.e., no processor or decoder action is taken on it).

If on the other hand, it is determined at decision **408** that the generated voltage is within a predetermined range, then the keypress which generated the voltage is decoded, for example in decoder **212** of FIG. 2. Optionally, the flow continues to block **412** where the input voltage to the passive network is altered, for example as described above with respect to controller **220**. In either case, the flow returns to block **402** to generate a voltage in response to the next key press.

As described above, the present invention is a method and circuit for differentiating between input ranges in a passive network keypad which allows the proper processing of meaningful keypresses, while ignoring inadvertent or superfluous keypresses, thereby conserving power and processor time.

The previous description of the preferred embodiments is provided to enable any person skilled in the art to make or use the present invention. The various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

**Claims**

1. A circuit for processing switch closures in a passive network having switches, said passive network generating a voltage in response to a switch closure, the circuit comprising:

   a comparison circuit (206), coupled to said passive network, for comparing said voltage to a reference voltage; and

   a decoder (212), coupled to said comparison circuit (206), for decoding said switch closure if said voltage is within a predetermined range, wherein said decoder (212) does not decode said switch closure if said voltage is not within said predetermined range, **characterised in that** there is provided a switch corresponding to a power-on key, wherein said comparison circuit generates an interrupt signal to said decoder only if said switch is closed.

2. The circuit of claim 1 wherein said comparison circuit (206) comprises:

   at least one comparator (208A-208N), each comparator having a first input coupled to said passive network and having a second input and an output for generating a comparison signal; and

   at least one reference voltage generator (212A-212N), each reference voltage generator coupled to said second input of a respective one of said comparators (208A-208N), each of said reference voltage generators (212A-212N) for generating a respective reference voltage;

   wherein said predetermined range is defined by said reference voltages.

3. The circuit of claim 2 wherein said comparison circuit (206) further comprises a range determination logic circuit (210) coupled to each of said comparator outputs, said range determination logic (210) for distinguishing between different ranges of said voltages generated by said passive network.

4. The circuit of claim 2 wherein said comparison circuit (206) comprises:

   a first comparator (208A) for generating said comparison signal only if a first predetermined subset of said switches is closed; and

   a second comparator (208B) for generating said comparison signal only if a second predetermined subset of switches is closed.

5. The circuit of claim 1 wherein said comparison circuit (206) generates said interrupt signal to said decoder (212) only if said voltage is within said predetermined range.

6. The circuit of claim 5 wherein said predetermined range corresponds to a predetermined subset of said switches.

7. The circuit of claim 1 further comprising a controller, coupled to said decoder, for altering an input voltage of said passive network in response to said decoder decoding said switch closure.

8. A method for processing switch closures in a passive network having switches, said passive network generating a voltage in response to a switch closure, the method comprising the steps of:

comparing said voltage to a reference voltage;
decoding said switch closure if said voltage is within a predetermined range;
ignoring said switch closure if said voltage is not within said predetermined range; and
generating an interrupt signal only if said voltage is within said predetermined range wherein said interrupt signal is generated only if a switch corresponding to a power-on key is closed.

9. The method of claim 8 wherein said predetermined range is defined by said reference voltage.

10. The method of claim 9 further comprising the step of distinguishing between different ranges of said voltages generated by said passive network.

11. The method of claim 8 further comprising the step of generating said interrupt signal only if said voltage is within said predetermined range.

12. The method of claim 11 wherein said predetermined range corresponds to a predetermined subset of said switches.

13. The method of claim 8 further comprising the step of altering an input voltage of said passive network in response to said decoder decoding said switch closure.

**Patentansprüche**

1. Eine Schaltung zur Verarbeitung von Schalterschließungen in einem passiven Netzwerk mit Schaltern, wobei das passive Netzwerk eine Spannung ansprechend auf eine Schalterschließung generiert, wobei die Schaltung Folgendes aufweist:

eine Vergleichsschaltung (206), die an das passive Netzwerk gekoppelt ist, zum Vergleichen der Spannung mit einer Referenzspannung; und
ein Decoder (212), der an die Vergleichsschaltung (206) gekoppelt ist, zum Decodieren der Schalterschließung, wenn die Spannung innerhalb eines vorbestimmten Bereichs liegt, wobei der Decoder (212) nicht die Schalterschließung decodiert, wenn die Spannung nicht innerhalb des vorbestimmten Bereiches liegt, **dadurch gekennzeichnet, dass** ein Schalter, der einer Anschalttaste entspricht, vorgesehen ist, wobei die Vergleichsschaltung ein Interrupt- bzw. Unterbrechungssignal für den Decoder generiert, und zwar nur, wenn der Schalter geschlossen ist.

2. Die Schaltung nach Anspruch 1, wobei die Vergleichsschaltung (206) Folgendes aufweist:

zumindest einen Vergleicher (208A-208N), wobei jeder Vergleicher einen ersten Eingang, gekoppelt mit dem passiven Netzwerk besitzt, und einen zweiten Eingang besitzt, sowie einen Ausgang zum Generieren eines Vergleichssignals; und
zumindest einen Referenzspannungsgenerator (212A-212N), wobei jeder Referenzspannungsgenerator an den zweiten Eingang eines jeweiligen der Vergleicher (208A-208N) gekoppelt ist, wobei jeder der Referenzspannungsgeneratoren (212A-212N) zum Generieren einer jeweiligen Referenzspannung dient;

wobei der vorbestimmte Bereich durch die Referenzspannungen definiert ist.

3. Die Schaltung nach Anspruch 2, wobei die Vergleichsschaltung (206) weiterhin eine Bereichsbestimmungslogikschaltung (210), gekoppelt an jede der Vergleicherausgänge aufweist, wobei die Bereichsbestimmungslogik (210) zum Unterscheiden zwischen verschiedenen Bereichen der Spannungen, die durch das passive Netzwerk generiert werden, dient.

4. Die Schaltung nach Anspruch 2, wobei die Vergleichsschaltung (206) Folgendes aufweist:

einen ersten Vergleicher (208A) zum Generieren des Vergleichssignals, und zwar nur wenn eine erste vorbestimmte Teilgruppe der Schalter geschlossen ist; und

einen zweiten Vergleicher (208B) zum Generieren des Vergleichssignals, und zwar nur wenn eine zweite vorbestimmte Teilgruppe der Schalter geschlossen ist.

**5.** Die Schaltung nach Anspruch 1, wobei die Vergleichsschaltung (206) das Unterbrechungssignal für den Decoder (212) generiert, und zwar nur dann wenn die Spannung innerhalb des vorbestimmten Bereichs liegt.

**6.** Die Schaltung nach Anspruch 5, wobei der vorbestimmte Bereich einer vorbestimmten Teilgruppe der Schalter entspricht.

**7.** Die Schaltung nach Anspruch 1, die weiterhin eine Steuerung, gekoppelt an den Decoder aufweist, und zwar zum Verändern einer Eingangsspannung des passiven Netzwerks, ansprechend auf die Decodierung der Schalterschließung durch den Decoder.

**8.** Ein Verfahren zum Verarbeiten von Schalterschließungen in einem passiven Netzwerk mit Schaltern, wobei das passive Netzwerk eine Spannung, ansprechend auf eine Schalterschließung generiert, wobei das Verfahren die folgenden Schritte aufweist:

Vergleichen der Spannung mit einer Referenzspannung;
Decodieren der Schalterschließung, wenn die Spannung innerhalb eines vorbestimmten Bereiches liegt;
Ignorieren der Schalterschließung, wenn die Spannung nicht innerhalb des vorbestimmten Bereichs liegt; und
Generieren eines Unterbrechungs- bzw. Interruptsignals, und zwar nur dann wenn die Spannung innerhalb des vorbestimmten Bereichs liegt,

wobei das Unterbrechungssignal nur generiert wird, wenn ein Schalter entsprechend einer Anschalt-Taste (power-on key) geschlossen ist.

**9.** Das Verfahren nach Anspruch 8, wobei der vorbestimmte Bereich durch die Referenzspannung definiert ist.

**10.** Das Verfahren nach Anspruch 9, das weiterhin den Schritt des Unterscheidens zwischen verschiedenen Bereichen der Spannungen, generiert durch das passive Netzwerk, aufweist.

**11.** Das Verfahren nach Anspruch 8, das weiterhin den Schritt des Generierens des Unterbrechungssignals, und zwar nur dann wenn die Spannung innerhalb des vorbestimmten Bereiches liegt, aufweist.

**12.** Das Verfahren nach Anspruch 11, wobei der vorbestimmte Bereich einer vorbestimmten Teilgruppe der Schalter entspricht.

**13.** Das Verfahren nach Anspruch 8, das weiterhin den Schritt des Veränderns einer Eingangsspannung des passiven Netzwerks, ansprechend auf das Decodieren der Schalterschließung durch den Decoder aufweist.


**Revendications**

**1.** Circuit de traitement de fermetures de commutateurs dans un réseau passif comprenant des commutateurs, le réseau passif produisant une tension en réponse à une fermeture de commutateur, le circuit comprenant :

un circuit de comparaison (206) couplé au réseau passif, pour comparer ladite tension à une tension de référence ; et
un décodeur (212) couplé au circuit de comparaison (206) pour décoder ladite fermeture de commutateur si la tension est à l'intérieur d'une plage prédéterminée, le décodeur (212) ne décodant pas la fermeture de commutateur si ladite tension n'est pas dans ladite plage prédéterminée,

**caractérisé en ce qu'**il est prévu un commutateur correspondant à une clé de mise en route, le circuit de comparaison produisant un signal d'interruption pour le décodeur seulement si le commutateur est fermé.

**2.** Circuit selon la revendication 1, dans lequel le circuit de comparaison (206) comprend :

au moins un comparateur (208A-208N), chaque comparateur ayant une première entrée couplée au réseau passif, une seconde entrée, et une sortie pour produire un signal de comparaison ; et
au moins un générateur de tension de référence (212A-212N), chaque générateur de tension de référence étant couplé à la seconde entrée de l'un respectif des comparateurs (208A-208N), chaque générateur de tension de référence (212A-212N) étant destiné à produire une tension de référence respective ;

dans lequel ladite plage prédéterminée est définie par les tensions de référence.

3. Circuit selon la revendication 2, dans lequel le circuit de comparaison (206) comprend en outre un circuit logique de détermination de plage (210) couplé à chacune des sorties du comparateur, le circuit logique de détermination de plage (210) étant destiné à distinguer différentes plages desdites tensions produites par le réseau passif.

4. Circuit selon la revendication 2, dans lequel le circuit de comparaison (206) comprend :

un premier comparateur (208A) pour produire le signal de comparaison seulement si un premier sous-ensemble desdits commutateurs est fermé ; et
un second comparateur (208B) pour produire le signal de comparaison seulement si un second sous-ensemble prédéterminé des commutateurs est fermé.

5. Circuit selon la revendication 1, dans lequel le circuit de comparaison (206) produit le signal d'interruption pour le décodeur (212) seulement si ladite tension est à l'intérieur de la plage prédéterminée.

6. Circuit selon la revendication 5, dans lequel la plage prédéterminée correspond à un sous-ensemble prédéterminé desdits commutateurs.

7. Circuit selon la revendication 1, comprenant en outre un contrôleur couplé au décodeur pour modifier la tension d'entrée du réseau passif en réponse au décodage par le décodeur de la fermeture de commutateur.

8. Procédé pour traiter des fermetures de commutateurs dans un réseau passif comprenant des commutateurs, le réseau passif produisant une tension en réponse à une fermeture de commutateur, le procédé comprenant les étapes suivantes :

comparer ladite tension à une tension de référence ;
décoder la fermeture de commutateur si la tension est à l'intérieur d'une plage prédéterminée ;
ignorer la fermeture de commutateur si ladite tension n'est pas dans la plage prédéterminée ; et
produire un signal d'interruption seulement si ladite tension est à l'intérieur de la plage prédéterminée, le signal d'interruption étant produit seulement si un commutateur correspondant à une touche de mise en route est fermé.

9. Procédé selon la revendication 8, dans lequel la plage prédéterminée est définie par ladite tension de référence.

10. Procédé selon la revendication 9, comprenant en outre l'étape consistant à distinguer entre les différentes plages de tension produites par le réseau passif.

11. Procédé selon la revendication 8, comprenant en outre l'étape consistant à produire le signal d'interruption seulement si ladite tension est à l'intérieur de la plage prédéterminée.

12. Procédé selon la revendication 11, dans lequel la plage prédéterminée correspond à un sous-ensemble prédéterminé des commutateurs.

13. Procédé selon la revendication 8, comprenant en outre l'étape consistant à modifier la tension d'entrée du réseau passif en réponse au décodage par le décodeur de la fermeture de commutateur.

FIG. 1

FIG. 2

DECODER — 212

CONTROLLER — 220

POWER SUPPLY — 102

A/D CONVERTER — 204

206

RANGE DETERMINATION LOGIC — 210

COMP — 208A
COMP — 208B
COMP — 208N

REF — 212A
REF — 212B
REF — 212N

Vout

212

S1  S2  S3  Sn

R1  R2  R3  Rn

100

FIG. 3

402

GENERATE A VOLTAGE IN A
PASSIVE NETWORK
IN RESPONSE TO A KEY PRESS

404

COMPARE THE VOLTAGE
TO A REFERENCE VOLTAGE

406

IGNORE
KEYPRESS

408

IS
VOLTAGE IN
PREDETERMINED
RANGE?

NO

YES

410

DECODE
KEYPRESS

412

ALTER INPUT VOLTAGE
TO PASSIVE NETWORK

FIG. 4